(19) **Europäisches Patentamt European Patent Office Office européen des brevets**

(11) **EP 1 783 783 A1**

(12) **EUROPEAN PATENT APPLICATION**
published in accordance with Art. 158(3) EPC

(43) Date of publication:
**09.05.2007 Bulletin 2007/19**

(21) Application number: **05768903.6**

(22) Date of filing: **05.08.2005**

(51) Int Cl.:
***H01B 5/00*** (2006.01)   ***C23C 18/52*** (2006.01)
***C23C 18/31*** (2006.01)

(86) International application number:
**PCT/JP2005/014440**

(87) International publication number:
**WO 2006/018995 (23.02.2006 Gazette 2006/08)**

(84) Designated Contracting States:
**DE FR GB**

(30) Priority: **05.08.2004 JP 2004229651**

(71) Applicant: **SEKISUI CHEMICAL CO., LTD.**
**Osaka-shi,**
**Osaka 530-8565 (JP)**

(72) Inventor: **KUBOTA, Takashi,**
**c/o Sekisui Chemical Co. Ltd.**
**Koka-shi, Shiga 5288585 (JP)**

(74) Representative: **Hart Davis, Jason et al**
**Cabinet Beau de Loménie,**
**158, rue de l'Université**
**75340 Paris Cedex 07 (FR)**

(54) **CONDUCTIVE FINE PARTICLE, METHOD FOR PRODUCING CONDUCTIVE FINE PARTICLE AND ELECTROLESS SILVER PLATING LIQUID**

(57)    It is an object of the present invention to provide a conductive fine particle which can prevent conductive defects and makes it possible to reduce the connection resistance, a method for producing the conductive fine particle, and an electroless silver plating liquid used for the producing of the conductive fine particle.

The present invention is directed to a conductive fine particle, which comprises: a base particle; a base layer made of nickel on the surface of the base particle; and a silver layer formed by electroless silver plating on the surface of the base layer, the purity of silver in the silver layer being 90 wt % or more.

EP 1 783 783 A1

**Description**

TECHNICAL FIELD

The present invention relates to a conductive fine particle which can prevent conductive defects and makes it possible to reduce the connection resistance, a method for producing the conductive fine particle, and an electroless silver plating liquid used for the producing of the conductive fine particle.

BACKGROUND ART

Conductive fine particles are generally mixed into a binder resin or the like, which are widely used as anisotropic conductive materials such as anisotropic conductive pastes, anisotropic conductive inks, anisotropic conductive adhesives, anisotropic conductive films and anisotropic conductive sheets. These anisotropic conductive materials are used in such a manner as to be sandwiched between, for example, wire printed circuit substrates and electrode terminals in order to electrically connect wire printed circuit substrates to each other, and to electrically connect compact parts such as semiconductor elements to a wire printed circuit substrate in electronic apparatuses such as liquid crystal displays, personal computers and cellular phones.

Conductive fine particles, where nonconductive fine particles such as resin particles or glass beads having a uniform particle diameter are used as base particles and a plating of a metal such as nickel is formed on the surface of the base particles, have been reported as conventional conductive fine particles which are appropriate for anisotropic conductive materials. However, a problem arises where the plating layer of conductive fine particles where nickel is plated corrodes with time, increasing the electrical resistance.

As a measure to solve such a problem, conductive fine particles where a gold layer or a silver layer is additionally formed on the surface of conductive fine particles that have been plated with nickel have been reported. Patent Document 1, for example, discloses conductive fine particles where a base layer made of nickel and a copper layer which covers the base layer are formed by electroless plating on the surface of base particles, which are fine particles, and furthermore, a silver layer is formed on the surface of the copper layer by electroless plating. Patent Document 2, for example, discloses conductive fine particles where a base layer made of nickel is formed by electroless plating on the surface of substantially spherical resin fine particles, and after that, a gold layer is formed using a gold cyanide.

The method disclosed in Patent Document 1, however, is not a method for directly forming a silver layer on the base layer made of nickel, but a substitute type electroless silver plating method where the base layer is once coated with a copper layer, and the copper layer that has been formed on the surface of the base layer is gradually substituted with a silver layer by making a substitution reaction between copper and silver occur. There is a problem with this method where a complex process for coating the base layer once by electroless copper plating is required in order to carry out silver plating on the surface of the base layer.
In addition, according to this method, a slight amount of copper of approximately 0.1 wt % remains in the composition of the silver layer. Copper and silver easily interdiffuse, and therefore, copper diffuses into the silver layer with time and becomes an impurity component in the silver layer. Copper is easily subjected to oxidation in comparison with silver, and therefore, the copper that has diffused in the silver layer is gradually oxidized and becomes copper oxide. As a result of this, a problem arises where the resistance value of the conductive fine particles increases twice or more with time, though the initial resistance value is low.

Meanwhile, in the case where gold plating or silver plating is carried out in accordance with a method as that disclosed in Patent Document 2, a cyanogen plating bath is usually used where a cyanide plating liquid containing a cyanogen compound such as gold cyanide or silver cyanide is used for excellent stabilization of the plating bath.
However, such a cyanogen plating bath is strongly alkaline, and therefore, problems arise where base particles are eaten away to a great extent, and the usage of such a bath is harmful to the environment.
Accordingly, electroless silver plating using a cyanogen-free plating liquid which does not use a cyanogen compound or the like is desired, but when a silver layer is directly formed on the surface of the base layer made of nickel using a plating liquid which does not use a cyanogen compound, adhesiveness between the base layer and the silver layer is not sufficient, and a problem arises where conductive defects easily occur.

In addition, Patent Document 3 discloses conductive fine particles where a base layer made of nickel is formed by electroless plating on the surface of base particles, which are fine particles, and a silver layer is directly formed on the surface of the base layer made of nickel using a cyanogen-free plating liquid which contains a complexing agent such as sodium sulfite or succinimide and a reducing agent such as hydrazine or sodium phosphinate. In such conductive fine particles, it is not necessary to use copper, which easily interdiffuses with silver, and therefore, there is no need for the troublesome process of forming a copper layer, and the resistance value is not increased through the oxidation of copper that has diffused into the silver layer.
However, the actual resistance value of the conductive fine particles obtained in Patent Document 3 is high in spite of the high conductivity of silver.

Patent Document 1: Japanese Kokai Publication Hei-11-61424
Patent Document 2: Japanese Kokai Publication Hei-8-311655
Patent Document 3: Japanese Kokai Publication 2002-266079

DISCLOSURE OF THE INVENTION

PROBLEMS WHICH THE INVENTION IS TO SOLVE

In view of the above-mentioned state of the art, the present invention aims to provide a conductive fine particle which can prevent conductive defects and makes it possible to reduce the connection resistance, a method for producing the conductive fine particle, and an electroless silver plating liquid used for the producing of the conductive fine particle.

MEANS FOR SOLVING THE OBJECT

The present invention provides a conductive fine particle, which comprises: a base particle; a base layer made of nickel on the surface of the base particle; and a silver layer formed by electroless silver plating on the surface of the base layer, the purity of silver in the silver layer being 90 wt % or more.
Hereinafter, the present invention will be described in detail.
The present inventors found, as a result of diligent examination, that the resistance value of the conductive fine particles in Patent Document 3 was high because of the following reasons. The base particles that had been plated with nickel were microscopic powders, and therefore, the surface area of the coating film of the nickel plating which made contact with the plating bath became very large. When the electroless silver plating liquid and the coating film of the nickel plating made contact with each other, nickel elutes in the electroless silver plating liquid as much as a tiny amount. Therefore, in the case where a large amount of base particles that had been plated with nickel was added to the plating bath for the purpose of carrying out highly efficient plating, a large amount of nickel elutes in the electroless silver plating liquid. Since nickel cannot be prevented from eluting in the electroless silver plating liquid, the eluted nickel deposits together with silver when reducing type electroless silver plating was carried out using a conventional reducing agent such as hydrazine or a phosphinate as described in Patent Document 3, and therefore, the formed silver layer included a large amount of nickel as an impurity. In addition, the silver layer that included nickel became amorphous, and therefore, the resistance value of the obtained conductive fine particles was high in spite of the high conductivity of silver.
Therefore, the present inventors found, as a result of additional diligent examination, that by making the purity of silver in the silver layer of the conductive fine particles at a certain level or higher, the connection resistance could be reduced when circuit substrates or the like were made to adhere by pressure using the conductive fine particles, and thus, completed the present invention.
The conductive fine particle of the present invention comprises a base particle, a base layer made of nickel on the surface of the above-mentioned base particle and a silver layer formed by electroless silver plating on the surface of the above-mentioned base layer.
The material of the above-mentioned base particle may be an organic type or inorganic type material and is not particularly limited insofar as it has suitable elastic modulus, elastic deformation, and restoration, but the material is preferably an organic type material such as resin particle.
The above-mentioned organic type material is not particularly limited, and phenol resin, amino resin, polyester resin, urea resin, melamine resin, epoxy resin and divinylbenzene polymer; divinylbenzene type polymers such as a divinyl benzene-styrene copolymer and a divinyl benzene-(meth)acrylate ester copolymer; a (meth)acrylate ester polymer or the like can be cited as examples.
The above-mentioned (meth)acrylate ester polymer may be used a crosslinked polymer or non-crosslinked polymer, or a mixture of them, depending on the necessity. In particular, the divinyl benzene type polymer or (meth)acrylate ester type polymer is preferably used. As used herein, "(meth)acrylate ester" means methacrylate ester or acrylate ester.
The above-mentioned inorganic type material includes, for example, metal, glass, ceramics, metal oxides, metal silicates, metal carbides, metal nitrides, metal carbonates, metal sulfates, metal phosphates, metal sulfides, metal acid salts, metal halides, carbon or the like.
These base particles may be used solely or two or more types may be used together.
Though the form of base particles is not particularly limited, and it may be a specific form such as spherical form, fiber form, hollow form and needle form, or may be an amorphous form, it is preferable for it to be in spherical form in order to obtain appropriate electrical connections.
Though the particle diameter of the base particles is not particularly limited, a preferable lower limit is 1 $\mu$m

and a preferable upper limit is 100 μm. In the case of less than 1 μm, particles easily aggregate at the time of, for example, electroless plating, and when a circuit substrate or the like is conductively connected using conductive fine particles that have been produced from the aggregated base particles, short circuiting between adjacent electrodes may be caused, while in the case where the particle diameter exceeds 100 μm, the coating film of the plating of the obtained conductive fine particles is easily peeled, and the reliability in the conductivity may be reduced. A more preferable lower limit is 2 μm and a more preferable upper limit is 20 μm.

Though the CV value of the base particles is not particularly limited, a preferable upper limit is 10%. In the case where the CV value exceeds 10%, it becomes difficult for the obtained conductive fine particles to arbitrarily control the gap between facing electrodes. Here, the above-mentioned CV value is the value obtained by the way of dividing the standard deviation obtained from the distribution of the particle diameter by the average particle diameter and converting into percentage.

The above-mentioned base particles are coated with a base layer made of nickel.
Though the thickness of the above-mentioned base layer made of nickel is not particularly limited, a preferable lower limit is 3 nm and a preferable upper limit is 200 nm. In the case of less than 3 nm, a base layer having a sufficient strength may not be obtained, and even if the thickness exceeds 200 nm, it is not very meaningful to further increase the thickness because the required strength has sufficiently been achieved. A more preferable lower limit is 6 nm and a more preferable upper limit is 100 nm.

In the conductive fine particles of the present invention, a silver layer is formed by electroless silver plating on the surface of the above-mentioned base layer made of nickel.
In the conductive fine particles of the present invention, a silver layer is formed on the surface of the base layer made of nickel, and thereby, the electrical resistance does not increase as a result of the corrosion of the base layer with time, and the conductivity becomes excellent due to the silver layer having a low electrical resistance.

Though the thickness of the above-mentioned silver layer is not particularly limited, a preferable lower limit is 10 nm and a preferable upper limit is 80 nm. In the case of less than 10 nm, a fine and continuous silver layer may not be obtained, and as a result, a sufficient resistance to oxidation and conductivity may not be provided, and in the case where the thickness exceeds 80 nm, the specific gravity increases, and in addition, the required conductivity is sufficiently achieved using a large amount of expensive silver, and thus, it is not very meaningful to additionally increase the thickness. A more preferable lower limit is 20 nm and a more preferable upper limit is 50 nm.

In the conductive fine particles of the present invention, the purity of silver in the above-mentioned silver layer is 90 wt % or more. In the present invention, the purity of silver in the silver layer is high, and therefore, it becomes possible to lower the connection resistance for circuit substrates or the like. A preferable purity of silver is 95 wt % or more, and a more preferable purity of silver is 95.7 wt % or more.

As for a component other than silver in the above-mentioned silver layer, a phosphorous component included in the plating liquid or nickel that has eluted in the electroless silver plating liquid may be possible.
A preferable upper limit of the content of the phosphorous component is 4 wt %, a more preferable upper limit is 2 wt % and an even more preferable upper limit is 1.5 wt %. The content of the phosphorous component in the silver layer can be kept low by not using a complexing agent which contains a phosphorous component.
A preferable upper limit of the content of nickel is 6 wt %, a more preferable upper limit is 4 wt %, an even more preferable upper limit is 3 wt % and the most preferable upper limit is 2.8 wt %. The content of nickel in the silver layer can be kept low by using any of the after-mentioned reducing agents.

A method for measuring a component in the above-mentioned silver layer is not particularly limited, and a method for exposing a cross section by cutting a conductive fine particle using an energy dispersing X-ray spectrometer (EDX) and carrying out element mapping on the obtained cross section using the EDX for analysis processing can be cited as an example.

The method for producing conductive fine particles of the present invention is not particularly limited, and a method comprising: a base layer forming step of forming a base layer made of nickel by electroless nickel plating on the surface of base particles; and a silver layer forming step of forming a silver layer by electroless silver plating on the surface of the above-mentioned base layer can be cites as an example.

First, the base layer forming step is described in the following.
The method for forming a base layer made of nickel by electroless nickel plating on the surface of the base particles is not particularly limited, and a method for submerging base particles added a catalyst in a solution containing nickel ions in the presence of a reducing agent and depositing nickel on the surface of the base particles starting from the catalyst can be cited as an example.

The above-mentioned method for adding a catalyst is not particularly limited, and a method for submerging etched base particles in a solution of a mixture of palladium chloride and tin chloride, and after that, depositing palladium by activating the surface of the base particles with an acidic solution such as sulfuric acid or hydrochloric acid or an alkaline solution such as sodium hydroxide, and a method for submerging etched base particles in a palladium sulfate solution, and after that, depositing palladium by activating the surface of the base particles with a solution which contains a reducing agent such as dimethyl amine borane can be cited as examples.

The electroless nickel plating liquid used for the formation the base layer made of nickel is not particularly limited, and an electroless nickel plating liquid which contains a phosphorous based reducing agent such as phosphinic acid or a salt thereof, or sodium hypophosphite can be cited as an example.

In the case where an electroless nickel plating liquid which contains the above-mentioned phosphorous based reducing agent is used, the base layer made of nickel contains phosphorous.

It is preferable for the content of phosphorous in the above-mentioned base layer to be no higher than 20 wt %, it is more preferable for it to be 2 wt % to 15 wt % and it is most preferable for it to be 6 wt % to 14 wt %.

Next, the silver layer forming step is described.

The above-mentioned silver layer is formed by electroless silver plating. The method for forming a silver layer by electroless silver plating is not particularly limited, and though the method is not particularly limited as long as it is a method for forming a silver layer on the surface of the above-mentioned base layer made of nickel, a method using substrate-catalytic electroless silver immersion plating, for example, is appropriate for use because adhesiveness between the base layer and the silver layer becomes excellent. In addition to the method using substrate-catalytic electroless silver immersion plating, a method using autocatalytic electroless silver immersion plating or a method using electroless silver immersion plating, for example, may be used together.

A method using the above-mentioned substrate-catalytic electroless silver immersion plating is a method for depositing a silver layer using nickel in the nickel layer, which is the base layer as a catalyst.

In the method using the above-mentioned substrate-catalytic electroless silver immersion plating, a reducing agent which allows an oxidation reaction to occur on the surface of the base layer made of nickel and does not allow an oxidation reaction to occur on the surface of silver, which is a deposited metal, is provided on the surface of the base layer, and thus, silver is deposited by reducing the silver salt in the electroless silver plating liquid so that a silver plating coating film can be formed.

The electroless silver plating liquid used in the above-mentioned electroless silver plating is not particularly limited, and an electroless silver plating liquid which contains a water soluble silver salt, which is a silver ion source, and a complexing agent for stably dissolving silver ions can be cited in the same manner as general electroless silver plating liquids.

The above-mentioned water soluble silver salt is not particularly limited as long as it has water solubility, and cyanogen-free silver salts such as silver nitrate and silver sulfate, and cyanogen type silver salts such as silver cyanide can be cited as examples. Among them, cyanogen-free silver salts are preferable when taking environmental issues and the like into consideration.

Cyanogen-free electroless silver plating can be carried out by using the above-mentioned cyanogen-free silver salts, and this is not used with strong alkalis such as those used in cyanogen plating baths, and therefore, base particles and the like are not eaten, and attention is closely paid to the environment. From among the above-mentioned cyanogen-free silver salts, silver nitrate is preferable when taking dissolving properties in water into consideration.

Though the concentration of silver ions in the above-mentioned electroless silver plating liquid is not particularly limited, a preferable lower limit is 0.005 mol/L and a preferable upper limit is 0.2 mol/L. In the case of less than 0.005 mol/L, the amount of liquid becomes too great, leading to a reduction in productivity and a reduction in the reaction rate, whereas in the case where the concentration exceeds 0.2 mol/L, decomposition of the plating bath easily occurs.

The above-mentioned complexing agent is not particularly limited, and compounds having an amide group such as formamide, acetoamide, oxamic acid, compounds having an imido group such as imidosuccinate, organic acid or organic acid salts such as sulfurous acid, sulfite salts, citric acid and ammonium can be cited as examples. In particular, compounds having an imido group are preferable, and imidosuccinate is particularly preferable.

Though the amount of mixture of the above-mentioned complexing agent is not particularly limited, a preferable lower limit relative to silver ions is 0.8 times mol and a preferable upper limit is 10 times mol. In the case of less than 0.8 times mol, the effects of stably dissolving silver ions may be insufficient, while in the case of exceeding 10 times mol, excessive use occurs because the amount of use that is required for stabilizing silver ions has already been exceeded, and therefore, it is not efficient. A more preferable lower limit is 2 times mol and a more preferable upper limit is 6 times mol.

In the method for producing conductive fine particles, it is preferable in the above-mentioned step of forming a silver layer for the silver salt in the electroless silver plating liquid to be reduced using a reducing agent which allows an oxidation reaction to occur on the surface of the above-mentioned base layer and does not allow an oxidation reaction to occur on the surface of the above-mentioned silver layer.

The above-mentioned reducing agent works to make it easy for metal silver to be deposited through a reduction of silver ions in the plating liquid under the catalytic action of the base layer made of nickel, and is appropriately used to uniformly coat the surface of the base layer with a silver layer. By using such a reducing agent, the silver layer forming step becomes substrate-catalytic, and the above-mentioned reducing agent selectively reduces silver ions in the plating liquid rather than nickel that has eluted in the plating liquid, and therefore, a silver layer having an extremely high purity is formed on the surface of the base layer.

A method for producing a conductive fine particle, which comprises: a base layer forming step of forming a base layer made of nickel by electroless nickel plating on the surface of a base particle; and a silver layer forming step of forming a silver layer by electroless silver plating on the surface of the base layer, a silver salt in the electroless silver plating liquid being reduced by using a reducing agent which allows an oxidation reaction to occur on the surface of the base layer and does not allow an oxidation reaction to occur on the surface of the silver layer in the silver layer forming step also constitutes the present invention.

Though the above-mentioned reducing agent is not particularly limited, imidazole compounds are preferably used. The imidazole compounds are not particularly limited, and benzimidazole, imidazole-2-ethyl carboxylate, imidazole-4-acetate hydrochloride, imidazole-4-carboxyaldehyde, imidazole-4,5-dicarboxylate, imidazole-4,5-dicarbaxylate, 2-acetyl benzimidazole, 1-acetyl imidazole, 2-aminobenz imidazole, N-(3-amino propyl)imidazole, 4-azabenzimidazole, 1-benzylimidazole, 2-bromo-4,5-dichloroimidazole, 1-butyl imidazole, N,N'-carbonyl diimidazole, 2-chlorobenz imidazole, 4,5-dichloro-1-methyl imidazole, phenyl alkyl benzimidazole and 1,2-dimethyl-5-nitroimidazole can be cited as examples. Among them, benzimidazole is appropriately used because of the significant selectivity in such a manner that it allows an oxidation reaction to occur on the surface of the base layer made of nickel and does not allow an oxidation reaction to occur on the surface of silver, which is deposited metal.

Though the amount of mixture of the above-mentioned reducing agent is not particularly limited, a preferable lower limit relative to silver ions is 0.07 times mol and a preferable upper limit is 0.16 times mol. In the case of less than 0.07 times mol, the effects of stably dissolving silver ions may be insufficient while in the case where the amount of mixture exceeds 0.16 times mol, excessive use occurs because the amount of use that is required for stabilizing silver ions has already been exceeded, and therefore, it is not efficient. A more preferable lower limit is 0.08 times mol and a more preferable upper limit is 0.15 times mol.

Furthermore, in the case where substrate-catalytic electroless silver immersion plating is carried out, it is preferable for a crystal regulator to be contained in the electroless silver plating liquid.

By containing the above-mentioned crystal regulator, a substitution reaction between nickel and silver is suppressed, and the silver crystal is made to be fine so that adhesiveness between the nickel plating coating film and the silver plating coating film becomes excellent, and in addition, occurrence of pinholes is suppressed, so conductive fine particles having a very low resistance can be obtained.

Though the above-mentioned crystal regulator is not particularly limited, glyoxylic acid is preferably used. Though the amount of mixture of the above-mentioned crystal regulator is not particularly limited, a preferable lower limit relative to silver ions is 0.05 times mol and a preferable upper limit is 0.55 times mol. In the case of less than 0.05 times mol, the effects of stably dissolving silver ions may be insufficient while in the case where the amount of mixture exceeds 0.55 times mol, excessive use occurs because the amount of use that is required for stabilizing silver ions has already been exceeded, and therefore, it is not efficient. A more preferable lower limit is 0.06 times mol and a more preferable upper limit is 0.50 times mol.

As the above-mentioned electroless silver plating liquid, a liquid which contains a water soluble silver salt or the like, an imidazole compound, which is a reducing agent, and a glyoxylic acid, which is a crystal regulator, is used to carry out electroless silver plating on the base layer made of nickel, and thereby, a uniform silver layer having excellent adhesiveness can be formed without using a cyanogen compound, and furthermore, conductive fine particles having excellent conductivity can be obtained.

In addition, an electroless silver plating liquid which contains a water soluble silver salt, a complexing agent, an imidazole compound and glyoxylic acid as above-mentioned also constitutes the present invention. Such an electroless silver plating liquid can be appropriately used for the production of the conductive fine particles of the present invention.

A well known component such as a buffering agent can be additionally mixed, if necessary, into the above-mentioned electroless silver plating liquid.

Though the pH of the above-mentioned electroless silver plating liquid is not particularly limited, a preferable lower limit is 5 and a preferable upper limit is 10. In the case of less than 5, there is a risk that the rate of deposition of silver may be very slow while in the case where the pH exceeds 10, there is a risk that the reaction rate increases, making the plating liquid unstable. A more preferable lower limit is 6 and a more preferable upper limit is 9.

Though the temperature of the above-mentioned electroless silver plating liquid is not particularly limited, a preferable lower limit is 0°C and a preferable upper limit is 80°C. In the case of less than 0°C, the rate of deposition of silver may be too slow, reducing the productivity, while in the case where the liquid temperature exceeds 80°C, the reaction may be too strong and a uniform silver plating coating film may not be obtained. A more preferable lower limit is 15°C and a more preferable upper limit is 70°C.

In addition, the time for reaction during which the electroless silver plating reaction occurs may be set to a time for obtaining a desired amount of deposition, which is found by carrying out a test or the like in advance, and a range from 5 minutes to 60 minutes is preferable, and a range from 7 minutes to 40 minutes is more preferable.

The method for using the above-mentioned electroless silver plating liquid to plate particles to be plated, which are base particles on which a nickel plating coating film has been formed, is not particularly limited, and a method for directly putting particles to be plated into an electroless silver plating liquid, into which a silver salt, a complexing agent, a reducing agent, a crystal regulator, a buffering agent and the like have been mixed in advance and where the pH and the temperature have been adjusted; a method for putting particles to be plated by slurry, where particles to be plated are dispersed in water, into an electroless silver plating liquid that has been adjusted in the same manner as above; and a method for dispersing particles to be plated in an electroless silver plating liquid that has been prepared so that plating components are partially excluded, and after that, adding the remaining plating components can be cited as examples.

EFFECTS OF THE INVENTION

According to the present invention, by making the purity of silver in the silver layer of the conductive fine particles at a certain range, the connection resistance can be reduced when a circuit substrate or the like is made to adhere by pressure using the conductive fine particles.
According to the present invention, conductive fine particle which can prevent conductive defects and makes it possible to reduce the connection resistance; a method for producing the conductive fine particle; and an electroless silver plating liquid used for the producing of the conductive fine particle can be provided.

BEST MODE FOR CARRYING OUT THE INVENTION

Hereinafter, the present invention will be described in details with reference to examples, however the present invention is not limited to these examples.

(Example 1)

(1) Electroless nickel plating

10 g of divinylbenzene polymer resin particles ("Micropearl SP-205", made by Sekisui Chemical Co., Ltd.), of which the average particle diameter was 5 $\mu$m and the CV value was 5%, was etched and washed with water and then added to 100 mL of a palladium catalyst liquid which contained 8 wt % of a palladium catalyst, and the mixture was stirred. After that, the particles were collected through filtering and washed with water. Furthermore, the particles were added to a liquid of 0.5 wt % of dimethyl amine borane, of which the pH had been adjusted to 6, and thus, resin particles that had been activated with palladium were obtained.
500 mL of distilled water was added to the obtained resin particles that had been activate with palladium so that the particles were sufficiently dispersed and a suspension was obtained. An electroless nickel plating liquid comprised 50 g/L of nickel sulfate hexahydrate, 20 g/L of sodium hypophosphite monohydrate and 50 g/L of citric acid, of which the pH had been adjusted to 7.5, was gradually added to this suspension while the mixture was being stirred, and thus, electroless nickel plating was carried out. At this time, particles were periodically sampled during the electroless nickel plating so that the thickness of the coating film, of which the main component was nickel, was measured, and at the point in time when the thickness became 0.1 $\mu$m, the addition of the electroless nickel plating liquid was stopped, and the particles were collected through filtering and washed with water, which was then replaced with alcohol, and after that, dried in a vacuum, and thus, particles on which a nickel plating coating film had been formed were obtained. Here, the thickness $t_{Ni}$ of the coating film, of which the main component was nickel, was calculated in the following formula.

$$t_{Ni} \ (\mu m) \ = \ (\rho_P \times W_{Ni} \times D)/\{6 \times \rho_{Ni} \times (100 - W_{Ni})\}$$

(Here, $\rho_P$ is the specific gravity of the resin particles, $\rho_{Ni}$ is the specific gravity of the coating film, of which the main component was nickel, $W_{Ni}$ is the content (wt %) of nickel in the particles on which a nickel plating coating film had been formed, and D is the average particle diameter ($\mu$m) of the resin particles.)

(2) Electroless silver plating

Next, 15 g of benzimidazole, which was a reducing agent, was added to and dissolved in a solution where 4.25 g of silver nitrate, which is a silver salt, was dissolved in 1180 mL of pure water at room temperature, and after it was confirmed that the originally produced precipitation was completely dissolved, 25 g of imidosuccinate and 3.5 g of citric acid monohydrate, which were complexing agents, were dissolved, and after that, 10 g of glyoxylic acid, which was a crystal regulator, was put in and completely dissolved, and thus, an electroless silver plating liquid was prepared.

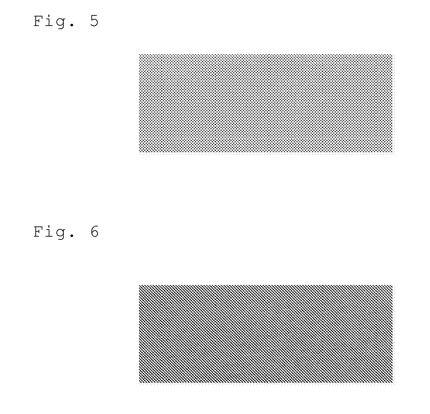

Next, the obtained particles on which a nickel plating coating film had been formed were put into the electroless silver plating liquid, and this solution was heated while being stirred, and the temperature was maintained at 70°C. After that, the particles were separated through filtering with a Buchner funnel, and approximately 1000 mL of pure water was poured onto the separated particles, which were thus washed. After that, the water was replaced with alcohol and the particles were dried in a vacuum dryer for 2 hours at 80°C, and thus, conductive fine particles were obtained. An enlarged image of the silver layer of the obtained conductive fine particles is shown in Fig. 5.

(Example 2)

In the same manner as in Example 1, electroless nickel plating was carried out, and particles on which a nickel plating coating film had been formed were obtained.

Next, 15 g of benzimidazole, which was a reducing agent, was added to and dissolved in a solution where 4.25 g of silver nitrate, which is a silver salt, was dissolved in 1180 mL of pure water at room temperature, and after it was confirmed that the originally produced precipitation was completely dissolved, 25 g of ammonium and 15 g of citric acid monohydrate, which were complexing agents, were dissolved, and after that, 10 g of glyoxylic acid, which was a crystal regulator, was put in and completely dissolved, and thus, an electroless silver plating liquid was prepared.

Next, the obtained particles on which a nickel plating coating film had been formed were put into the electroless silver plating liquid, and this solution was heated while being stirred, and the temperature was maintained at 50°C. After that, the particles were separated through filtering with a Buchner funnel, and approximately 1000 mL of pure water was poured onto the separated particles, which were thus washed. After that, the water was replaced with alcohol and the particles were dried in a vacuum dryer for 2 hours at 80°C, and thus, conductive fine particles were obtained.

(Comparative Example 1)

In the same manner as in Example 1, electroless nickel plating was carried out, and particles on which a nickel plating coating film had been formed were obtained.

The obtained particles on which a nickel plating coating had been formed were added to 100 mL of a palladium catalyst liquid which contained 8 wt % of a palladium catalyst, and the mixture was stirred. After that, the particles were collected through filtering and washed with water. Furthermore, the particles were added to a liquid of 0.5 wt % of dimethyl amine borane, of which the pH had been adjusted to 6, and thus, particles on which a nickel plating coating film that had been activated with palladium had been formed were obtained.

500 mL of distilled water was added to the obtained particles on which a nickel plating coating film that had been activated with palladium had been formed so that the particles were sufficiently dispersed and a suspension was obtained. An electroless copper plating liquid comprised 50 g/L of copper sulfate pentahydrate, 20 g/L of formaldehyde and 50 g/L of EDTA, of which the pH had been adjusted to 11, was gradually added to this suspension while the mixture was being stirred, and thus, electroless copper plating was carried out. At this time, particles were periodically sampled during the electroless copper plating so that the thickness of the coating film, of which the main component was copper, was measured, and at the point in time when the thickness became $0.1 \mu m$, the addition of the electroless copper plating liquid was stopped, and the particles were collected through filtering and washed with water, which was then replaced with alcohol, and after that, dried in a vacuum, and thus, particles on which a copper plating coating film had been formed were obtained.

The obtained particles on which a copper plating coating film had been formed were put into a solution comprised 400 mL of pure water, 10 g of silver cyanide, 100 mL of ammonium and 10 g of citric acid monohydrate, of which the pH had been adjusted to 7, and a substitution silver plating reaction occurred for 20 minutes at 60°C, and thereby, particles on which a silver plating coating film had been formed were obtained. After that, the particles were separated through filtering using a Buchner funnel, and approximately 1000 mL of pure water was poured onto the separated particles, which were thus washed. After that, the water was replaced with alcohol and the particles were dried in a vacuum dryer for two hours at 80°C, and thus, conductive fine particles were obrained. An enlarged image of the silver layer of the obtained conductive fine particles is shown in Fig. 6.

(Comparative Example 2)

30 g of silicon oxide powder in spherical form, of which the average particle diameter was approximately 10 $\mu m$ (Silica Ace US-10, made by Mitsubishi Rayon Co., Ltd.), was weighed and added to 120 $cm^3$ of a solution in which 0.3 g of an amino alkyl silane coupling agent (trade name: KBE 903, made by Shin-Etsu Chemical Co., Ltd.) was dissolved, and the mixture was stirred for 10 minutes at room temperature. 0.15 $cm^3$ of a solution which contained 30 $cm^3$ of concentrated hydrochloric acid, 0.09 $mol/dm^3$ of palladium chloride ($PdCl_2$), 2.6 $mol/dm^3$ of tin chloride ($SnCl_2$) and 3.5 $mol/dm^3$ of hydrogen chloride was added to the above-mentioned solution, and the mixture was continuously stirred for an additional 10 minutes. The powder component was collected from this mixture using a Buchner funnel, and 150 cm$^3$ of diluted hydrochloric acid, of which the concentration was 1 mol/dm$^3$, was poured onto the filtered powder, which was thus washed, and after that, the powder was washed with 100 cm$^3$ of water and a silicon oxide powder, to which a catalyst adhered, was obtained.

The obtained catalyst adhering silicon oxide powder was added to 135 cm$^3$ of water, and the mixture was stirred so that the powder was dispersed, and thus, slurry was obtained. Separate from this, 850 cm$^3$ of a concentrated electroless nickel plating liquid (Sumer S-680, made by Japan Kanigen Co., Ltd.) and 3.96 dm$^3$ of pure water were added and mixed in a 5L beaker of which the temperature was adjusted to 43°C, and thus, a plating bath was obtained. The previously prepared slurry was added to this plating bath while being stirred. The stirring was continued while maintaining the temperature so that a reaction occurred for 40 minutes. After the reaction, the powder on which a nickel-phosphorous plating layer had been formed was collected through filtering using a Buchner funnel, and approximately 1 dm$^3$ of water was poured onto the powder, which was thus washed, and after that, the powder was collected and 105 cm$^3$ of water was again added, and the mixture was stirred so that the powder was dispersed, and thus, slurry was obtained.

6.69 g of imidosuccinate was added to and dissolved in a solution where 4.59 g of silver nitrate for silver plating was dissolved in 1.33 dm$^3$ of pure water at room temperature. Separately, a liquid where 2.86 g of sodium phosphinate was dissolved in 50 cm$^3$ of pure water was prepared. The above-mentioned silver nitrate solution was heated to and maintained at 46°C while being stirred. The previously obtained slurry was poured into this silver nitrate solution, and when the solution became homogeneous, adding the sodium phosphinate solution to the homogeneous solution little by little was immediately started. Stirring was maintained for an additional 30 minutes while maintaining the temperature. After that, the powder was separated through filtering using a Buchner funnel, and approximately 1 dm$^3$ of pure water was poured onto the separated powder, which was thus washed. After washing, the powder was collected into a Petri dish and dried for 2 hours in a vacuum dryer, of which the internal temperature was 40°C, and thus, conductive fine particles were obtained.

<Evaluation>

The conductive fine particles obtained in Examples 1 and 2 and Comparative Examples 1 and 2 were evaluated in the following manner. The results are shown in Tables 1 and 2.

(1) Measurement of adhesiveness of silver layer

A focused ion beam (FIB) was used to cut a conductive fine particle so as to expose a cross section, and the obtained cross section was observed with a transmission electron microscope (TEM), and thereby, the interface between the base layer and the silver layer was observed, and the existence of pinholes in the silver layer was checked, and thus, the adhesiveness between the base layer and the silver layer was evaluated.

(2) Measurement of resistance value of conductive fine particles

A microscopic compression tester ("DUH-200", made by Shimadzu Corporation) was used so that the resistance value could be measured in such a manner that a conductive fine particle was energized while being compressed, and the resistance was measured, and thereby, the resistance value of the conductive fine particle was measured.

(3) Measurement of Component of Silver Layer

A cross section was exposed by cutting a conductive fine particle using an energy dispersing X-ray spectrometer (EDX), and element mapping was carried out on the obtained cross section using the EDX for analysis processing, and thereby, each composite element in the components that formed the silver layer was identified and the composition ratio was found.
Table 1

| | adhesiveness of silver layer | | resistance value (Ω) of conductive fine particles when compressed by 10% | configuration of plating coating film |
|---|---|---|---|---|
| | state of interface between base layer and silver layer | existence of pinholes | | |
| Example 1 | without alloy layer | none | 0. 86 | nickel/silver |

(continued)

| | adhesiveness of silver layer | | resistance value (Ω) of conductive fine particles when compressed by 10% | configuration of plating coating film |
|---|---|---|---|---|
| | state of interface between base layer and silver layer | existence of pinholes | | |
| Example 2 | without alloy layer | none | 0. 98 | nickel/silver |
| Comparative Example 1 | with alloy layer | exist | 2. 5 | nickel/copper/silver |
| Comparative Example 2 | with alloy layer | none | 1. 1 | nickel/silver |

Table 2

| | composition ratio in silver layer | | |
|---|---|---|---|
| | nickel element | phosphorous element | silver element |
| Example 1 | 2.8wt% | 1. 5wt % | 95.7wt% |
| Comparative Example 2 | 12. 2wt % | 4. 7wt % | 83. 1wt % |

INDUSTRIAL APPLICABILITY

According to the present invention, there can be provided a conductive fine particle which can prevent conductive defects and makes it possible to reduce the connection resistance, a method for producing the conductive fine particle, and an electroless silver plating liquid used for the producing of the conductive fine particle.

BRIEF DESCRIPTION OF THE DRAWINGS

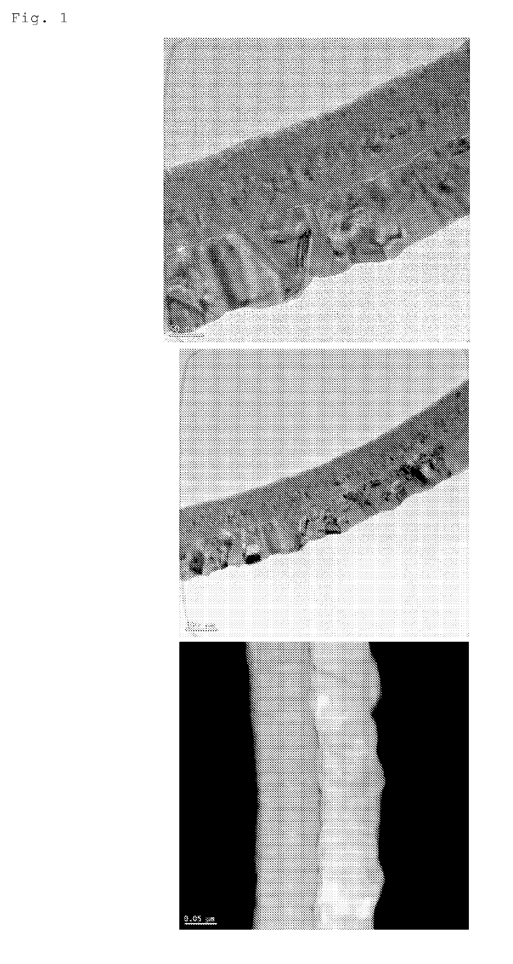

Fig. 1 shows TEM images of the conductive fine particles obtained in Example 1.

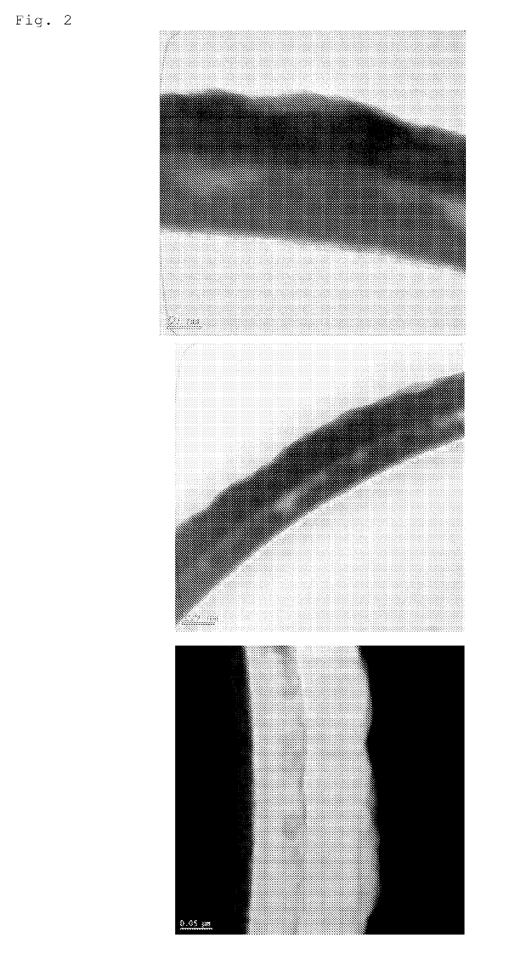

Fig. 2 shows TEM images of the conductive fine particles obtained in Comparative Example 2.

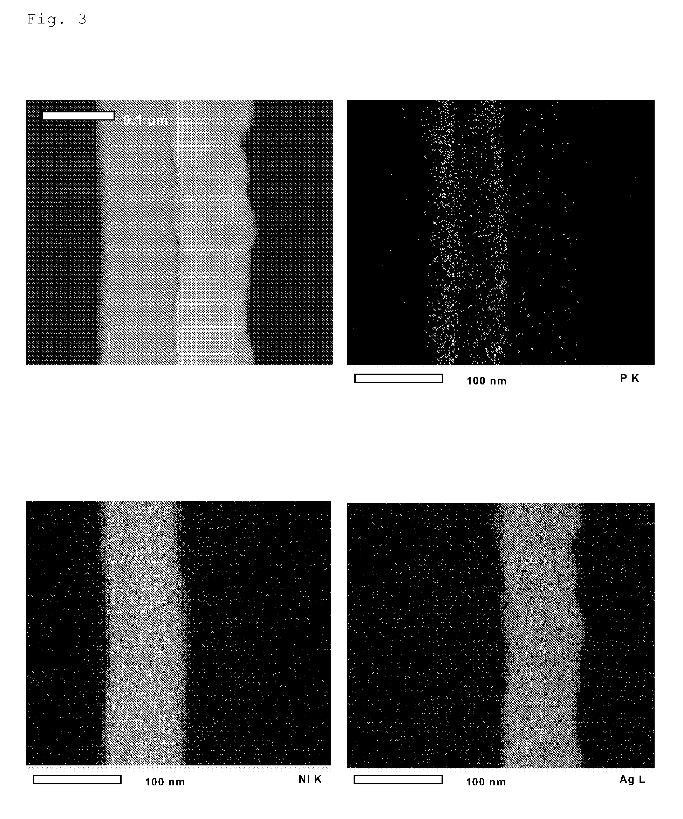

Fig. 3 shows images through EDX element analysis of the conductive fine particles obtained in Example 1.

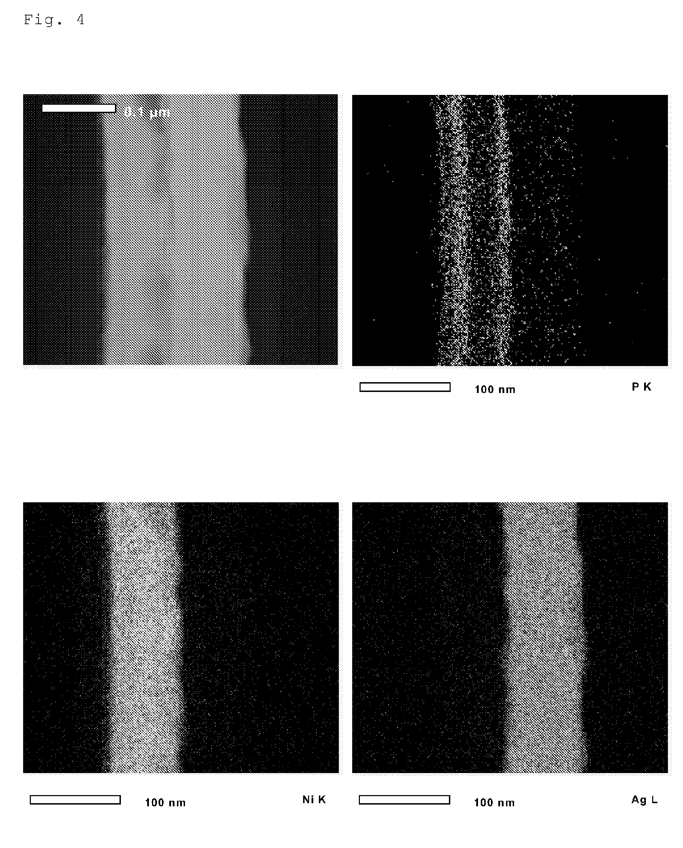

Fig. 4 shows images through EDX element analysis of the conductive fine particles obtained in Comparative Example 2.
Fig. 5 shows an enlarged image of the silver layer of the conductive fine particles obtained in Example 1.
Fig. 6 shows an enlarged image of the silver layer of the conductive fine particles obtained in Comparative Example 2.

**Claims**

1. A conductive fine particle,
   which comprises: a base particle; a base layer made of nickel on the surface of the base particle; and a silver layer formed by electroless silver plating on the surface of the base layer,
   the purity of silver in the silver layer being 90 wt % or more.

2. A method for producing a conductive fine particle,
   which comprises: a base layer forming step of forming a base layer made of nickel by electroless nickel plating on the surface of a base particle; and a silver layer forming step of forming a silver layer by electroless silver plating on the surface of the base layer,
   a silver salt in the electroless silver plating liquid being reduced by using a reducing agent which allows an oxidation reaction to occur on the surface of the base layer and does not allow an oxidation reaction to occur on the surface of the silver layer in the silver layer forming step.

3. The method for producing a conductive fine particle according to Claim 2,

wherein the reducing agent is an imidazole compound.

4.  The method for producing a conductive fine particle according to Claim 2 or 3,
    wherein glyoxylic acid is mixed into an electroless silver plating liquid in the silver layer forming step.

5.  An electroless silver plating liquid,
    which contains a water soluble silver salt, a complexing agent, an imidazole compound and glyoxylic acid.

Fig. 1

Fig. 2

Fig. 3

100 nm     P K

100 nm     Ni K

100 nm     Ag L

Fig. 4

100 nm                    P K

100 nm          Ni K

100 nm          Ag L

Fig. 5

Fig. 6

| **INTERNATIONAL SEARCH REPORT** | International application No. |
|---|---|
| | PCT/JP2005/014440 |

A. CLASSIFICATION OF SUBJECT MATTER
*H01B5/00* (2006.01), *C23C18/52* (2006.01), *C23C18/31* (2006.01)

According to International Patent Classification (IPC) or to both national classification and IPC

B. FIELDS SEARCHED

Minimum documentation searched (classification system followed by classification symbols)
*H01B5/00* (2006.01), *C23C18/52* (2006.01), *C23C18/31* (2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
JSTPlus(JOIS)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2002-266079 A (Shin-Etsu Chemical Co., Ltd.),<br>18 September, 2002 (18.09.02),<br>Full text<br>(Family: none) | 1<br>2-4<br>5 |
| Y | Hidemi NAWAFUNE · Keiko SHIROGUCHI · Shozo MIZUMOTO · Yasuhito KOFUNE · Keigo OBATA, "Imidazole o Kangenzai tosuru Neutral Succinimide Compley Bath kara no Mudenkai Nickel-Phosphorus Alloy Mekki Sozai eno Mudenkai Gin Mekki", The Journal of the Surface Finishing Society of Japan, Vol.52, No.11, pages 768 to 772 | 2-4 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 02 December, 2005 (02.12.05) | 13 December, 2005 (13.12.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 1 783 783 A1**

| INTERNATIONAL SEARCH REPORT | International application No. |
|---|---|
| | PCT/JP2005/014440 |

C (Continuation).   DOCUMENTS CONSIDERED TO BE RELEVANT

| Category* | Citation of document, with indication, where appropriate, of the relevant passages | Relevant to claim No. |
|---|---|---|
| Y | Keiko SHIROGUCHI · Hidemi NAWAFUNE · Shozo MIZUMOTO · Yasuhito KOFUNE · Takao TAKEUCHI, "Nickel Oyobi Do Sozaijo eno Non-Cyanide Chusei Mudenkai Gin Mekki", MES2000(Dai 10 Kai Micro Electronics Symposium), 2000 Nen 11 Gatsu, pages 147 to 150 | 2-4 |
| X<br>Y | Hidemi NAWAFUNE · Keiko SHIRUGUCHI · Shozo MIZUMOTO · Yasuhito KOHASHI · Keigo OBATA, "Direct Electroless Silver Plating on Copper Metal from Succinimide Complex Bath Using Imidazole as the Reducing Agent", The Journal of the Surface Finishing Society of Japan, Vol.52, No.10, 2001, pages 702 to 707 | 5<br>4 |

Form PCT/ISA/210 (continuation of second sheet) (April 2005)

**18**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11061424 A
- JP 8311655 A
- JP 2002266079 A